# EUROPEAN PATENT APPLICATION

(11) **EP 4 686 918 A1**
(43) Date of publication of application: **04.02.2026**
(21) Application number: 24191633.7
(22) Date of filing: 30.07.2024
(51) Int. Cl.: G01F 1/075, G01F 15/00, E03B 7/07, G01F 15/06, G01F 15/18, G01R 33/06, F17D 5/00, G05D 7/06, A47L 15/42, D06F 33/00

(54) **ELECTRONICALLY CONTROLLED BACK-FLOW PREVENTION**

(71) Applicant: Bleckmann GmbH & Co. KG, 5112 Lamprechtshausen (AT)
(72) Inventor: LEHNER, Ernst, 5082 Grödig (AT)
(74) Representative: Eisenführ Speiser

(57) **Abstract**

The application provides systems to prevent backflow from a household appliance. In some implementations, the system comprises a flow meter (603) for measuring water flow, wherein the flow meter (603) comprises a quadrature encoder providing a two channel signal, and control circuitry (606, 607). The control circuitry is configured to determine a flow direction based on a first signal of the first channel and a second signal of the second channel, and to provide a control signal for a valve (602) based on the determined flow direction. The application also provides associated methods and assemblies.

## Description

### Field

The present application relates to an electronic control system for preventing back flow of water from a household appliance, in particular for controlling a valve of a household appliance in order to avoid backward water flow from the inlet of the household appliance into the domestic water supply system.

### Background

Household appliances with a fixed water connection, for example washing machines and dishwashers, are connected to the water supply network. In such systems backflow from the device to the water supply network must be avoided. In particular, in case of pressure drops in the water supply network, backflow from the appliance into the water supply network can occur. Backflow, in particular from grey water circuits must be avoided in order to prevent contamination of the water supply.

New legislation may call for additional check valves in order to prevent backflow from appliances into the water supply. However, additional check valves are expensive and comprise movable parts within the path of the water, which due to an error or a malfunction may block the water supply or cause leakages.

Therefore, there is a need for a simple and inexpensive solution to prevent backflow from the appliance to the water supply network, preferably without having no or few additional parts in the path of the water.

### Summary

The present application provides an electronic solution to measure flow and to provide a corresponding control signal to a valve that cuts-off the connection between a household appliance and freshwater water supply.

It is known to provide a flow meter at or downstream of the inlet of a household appliance in order to measure the intake water flow into the appliance.

The present application provides a system that prevents backflow from a household appliance into the local freshwater water supply by electronically controlling a valve in accordance with the flow direction of the water.

According to a first aspect of the disclosed technology, a system to prevent backflow from a household appliance is provided. For example, a system to prevent backflow from a dishwasher or a washing machine into the local water supply. The system comprises a flow-meter for measuring the flow of water, wherein the flow meter comprises a quadrature encoder providing a two channel signal having a first signal on the first channel and a second signal on the second channel, and control circuitry to determine a flow direction based on the first signal of the first channel and a second signal of the second channel, and to provide a control signal for a valve based on the determined flow direction. Each signal of each channel may preferably be generated by a respective sensor.

In particular configurations, the flow meter is a conventional flow meter providing a tacho signal based on a single sensor measurement, wherein the flow meter comprises an additional sensor to provide a second signal, wherein the second signal is out of phase with the first signal. The system can be applied to commercially available appliances. For example, an existing, single channel, flow meter can be reconfigured by providing an additional sensor. The control circuitry can be based on existing electronic control platforms that are available. For example, electronic control platforms currently used to control dish washers or washing machines. For example, the Aweco AMP converter may be used. The signal of the quadrature encoder, which is formed by two sensors providing a two channel signal, wherein each signal is preferably 90° out of phase, may indicate the flow direction. For example, the sign of the phase difference between the two channels indicates that the water through the flow meter is in a forward direction, i.e. water is flowing from the water supply and into an inlet of the appliance through the flow, or in backward direction, i.e. water is flowing out of the inlet of the appliance and back into the local water supply. In some configurations, a positive/negative sign may indicate forward direction and negative/positive sign may indicate that the water flows in backward direction. Based on the determined flow direction the system may provide a control signal for a valve. In some configurations, the valve may be part of the system or may be a valve upstream of the inlet of the appliance, for example, an aqua stop valve. The flow meter may provide a signal that allows to determine the speed of an impeller of the flow meter. In some configurations, the system may provide a control signal closing the valve in case the flow direction through the flow meter is backwards. The control signal may alternatively be a digital signal, an analog signal, or a PWM (pulse width modulation) signal. The control signal may alternatively be a TTL signal, an analog voltage, or a software implemented digital input such as a storage variable. In some configurations, the valve may open in accordance with a high or true signal and close when receiving a low or false signal. In some configurations, the valve may open and close according to an analog voltage. In some configurations, the valve may open and close according to an digital voltage indicating a true or false state.

This solution allows to modify an existing flow meter by providing an additional sensor in order to provide a quadrature encoder. Therefore, the solution is versatile, easy to implement and inexpensive.

Preferably, the quadrature encoder comprises two sensors and at least one magnet, wherein the first sensor provides a first signal provided on a first channel and the second sensor provides a second signal provided on a second channel. Thereby, the flow meter can detect flow and direction by providing two out of phase signals. In case of backflow, the valve, for example the aqua stop valve, is closed upon receiving a corresponding control signal from the disclosed system. The control circuitry thereby advantageously replaces a mechanical solution, for example a check valve.

The sensors may be any sensor configured to detect magnetic fields, in particular the sensors may be configured to detect a change of the field direction. Providing two sensors and two sensors channels providing the signals of the sensors, wherein the sensors are aligned at an electrical phase angle of preferably 90° with respect to the measured entity, allows to determine the movement and the direction of the movement. The sensors may be Reed-Sensors or Hall-Sensors.

Nowadays household appliances utilize flow meters that provide a single channel signal typically generated by a reed switch that detects the magnetic field of a magnet rotating with the impeller of the flow meter. In case a magnet rotates about the axis of the impeller of the flow meter the frequency of the rotation can be determined, but not the direction. A single channel reed switch, for example, generates two pulses per revolution when the poles of a two pole magnet rotate in a circle about the rotational axis. However, the signal is the same for each direction of the rotation.

Two magnetic sensors, for example Hall- or Reed- Sensors mounted at an angle of preferably 90° with respect to the rotational axis and with respect to each other and a two pole magnet, which poles are arranged to rotate on a circle about the rotational axis of the impeller, allow for direction detection. The phase difference between the signal indicates the direction. For example, by comparing which signal leads the other signal the direction can be determined. Further, dual edge detection using rising and falling edges of one channel will result in the same resolution as the known single channel reed switch currently used in flow meters without direction sensing. Single edge detection using only one edge, rising or falling, of one channel will give half the resolution. Quad edge detection using the rising and falling edges of both channels will result in double resolution. Accordingly, the resolution may be changed by the used software or by programming. Therefore, the resolution may be adapted, for example, in cases where high resolution is necessary, the system can be configured to use quad edge detection.

Using Hall-Sensors instead of Reed-Sensor has the advantage that the sensors are smaller and more easily mounted.

Alternatively or additionally, the sensors used for the quadrature encoder may be bi-polar latching sensors. Advantageously, bi-polar latching sensors are more robust that Hall- or Reed-Sensors and provide a more reliable detection and corresponding signal.

Alternatively or additionally, the poles of the magnet rotating about the rotational axis of the impeller of the flow meter may cause a peak magnetic field of 100mT at the sensor. The switching threshold of the sensors may be 10mT.

Alternatively or additionally, the two signal channels may be provided on distinct signal lines that may be connected to I/O extension ports of commercially available electronic control circuitry for house hold appliances. For example, the electronic control circuit may connect the two sensors signals and an aqua stop valve using an appropriate driving circuit (e.g. a relay, power transistor, triac, etc.).

Alternatively or additionally, the control circuit may analyse the two channel signal, for example by determining the phase difference by analysing the switching pattern with respect to rising and falling edges. The phase difference or a particular switching patter of rising and falling edges may correspond to a particular rotational direction. For example, a first phase difference or switching patter corresponds the forward direction and a second phase difference or switching pattern corresponds to movement or rotation in the backward direction.

Preferably, the sensors are arranged in a plane perpendicular to the rotational axis of the flow meter, and the sensors are arranged on radial lines originating from the rotational axis of the flow meter, in particular an impeller of the flow meter, wherein the radial lines enclose an angle. By providing an angle between the measuring positions of the two signal of the two sensors, the signals generated by the sensors have a phase difference with respect to each other. In particular, in case the rotational speed is constant. Preferably, the angle may be between 45° and 135°, more preferably between 80° and 100°. The angle may be 90° causing the signal to be 90° out of phase. This configuration corresponds to a typical quadrature encoder. A 90° angle is particularly beneficial in terms of robustness against fluctuating rates of rotation. However, it has to be understood that any angle can be employed that allows to evaluate the direction of rotation via the phase difference.

A two channel signal with respect to a rotating encoder, for example a two pole magnet, wherein the signal switches with every sensed or detected change in magnetic field direction, allows to determine the rotational direction and the speed of the rotating element.

Preferably, the control circuitry is configured to provide a control signal that signals the valve to close in case the determined flow direction is backwards. The control signal may be received by a control circuit of the valve which opens or closes the valve in response to the control signal. The control signal may be a TTL signal or indicate a true or false state. Providing a control signal that indicate whether the valve shall close or open allows the system to operate with different types of valves. For example, the valve may be an electrically controlled water valve or aqua stop valve.

Preferably, the control circuitry comprises a direction detection circuit that analyses the two channel signal to determine the direction of the rotation of the impeller of the flow meter. The direction detection circuit may provide the result as a signal. The signal may be a digital signal encoding the result, wherein the result may be that the water flows in forward or backward direction. The signal may be a true or false signal, wherein the true signal corresponds to the water flowing in forward direction and a false signal corresponds to the water flowing in backward direction. The signal may be a TTL signal or an analog voltage. In principle, the signal may be any two state signal.

Preferably, the control circuitry further comprises a determination circuit comparing the determined flow direction with a preset flow direction and generating Boolean signal indicating whether the determined flow direction matches the preset flow direction, wherein the system further comprises an AND gate, wherein the Boolean signal generated by the determination circuit is provided to the AND gate and wherein the system further comprises an electronic control circuit controlling the water intake by providing a Boolean signal to initialize water flow, wherein the electronic control circuit provides the signal to the AND gate, and wherein the AND gate is connected to an signal input of an aqua stop valve. Preferably, the direction detection circuit may receive the two channel signal and determine the direction of the flow through the flow meter based on the two channel signal. The determination circuit may receive a signal indicating the flow direction from the direction detection circuit, for example in form a Boolean signal, wherein true indicates forward direction and false indicated the backward direction. However, any suitable signal may be used. The determination circuit may have stored a normal direction, which corresponds to normal operation, i.e. forward flow. The determination circuit may have a Boolean value or a value corresponding to the signal received from the direction detection circuit associated with the forward direction. For example, true may correspond to the forward direction. In such case, a true signal received from the direction detection circuit is recognized as to indicate the forward direction. The determination circuit, therefore, matches the received signal with a stored signal associated with the forward direction. In case the determination circuit determines that the signal matches the stored signal, the determination unit may provide a OK signal, for example a true or high signal or a corresponding analog voltage, in case the received signal does not match the value or signal associated with the forward direction the determination unit provides an ERROR signal, for example a false or low signal or a corresponding analog voltage. The determination circuit provides the generated output signal to a logical AND circuit. The logical AND is connected to a valve configured to shut of the water supply to the appliance. This configuration allows for a further condition in order to allow flow of water between the water supply and the appliance, since two true signals at each input of the AND circuit are needed in order to provide a true signal to the valve or the control circuit of the valve. For example, an additional true signal generated by the electronic control circuit of the appliance indicating that the appliance requests water. Further, the flow of water is immediately stopped in case the determination circuit provides an ERROR signal, since one false signal causes the AND to output a false. Therefore, the valve is stopped as soon as backward flow is determined regardless whether the electronic control circuit demands more water.

Preferably, the circuitry, in particular the determination circuit, provides an error signal in case the flow direction is backward and wherein the determination circuit provides an OK signal in case the flow direction is forward. By providing logic signal the control logic of a valve or an AND circuit can be operated.

Preferably, the system comprises the valve. The valve may be connected to the control circuit, in particular, the determination unit, which allows to provide a valve that can be controlled by the circuitry.

Preferably, the valve is a water valve at the inlet or an aqua stop valve of the appliance. The system is adapted to provide a signal that allows to control an aqua stop valve or a water valve at the inlet, thereby allowing interoperability with known systems, for example aqua stop valves. Thus, the system can be easily integrated in existing solution. Further, the system avoids additional mechanical parts in the path of the water, which may be damaged by the water by utilizing existing valves.

Preferably, the flow meter comprises an impeller and a magnet that rotates with the impeller. In particular, the poles of the magnet rotate on a circle around the rotational axis of the impeller. The magnet may act as an encoder for an impeller. The encoder may comprises at least, two, four, or any even number of magnetic poles. Providing a quadrature encoder linked with an impeller allows to determine the rotational frequency of the impeller and thereby to determine the amount of water flowing through the flow meter and the direction of the flow of water.

Preferably, wherein the magnet is a two-pole magnet and the poles rotate on a circle around the rotational axis of the flow meter. The solution only utilizes one signal magnet. Therefore, the solution is inexpensive and allows to provide at least a signal with each rotation. The system may comprise ring or disk magnet or arrangements of magnet comprising any number of even magnetic poles. These solutions advantageously increase the resolution. Therefore, magnets with four or more poles allow to detect backflow within less than half a revolution of the flow meter. Thus, the backflow is stopped earlier, compared to a magnet with only two poles. Preferably, when using more than two magnets, the sensors are arranged at an angle with respect to one another determined by 180° divided by the number of poles. For example, using two poles the sensors are arranged at a 90° angle. When using four poles, the sensors may be arranged at a 45° angle, etc.

In another aspect of the disclosed technology, an assembly for a household applicant comprising the above described system is provided. The system may be integrated with an assembly of a household appliance, for example a dish washer or a washing machine. The assembly may be part of the water intake system of the appliance.

Preferably, the assembly comprises a water inlet pocket. This allows to utilize existing assemblies for appliances, in particular water inlet pockets, which already comprise a single channel flow meter by providing an additional sensor and modifying the existing control electronics. Compatibility is ensured, since the assembly fits the appliance.

Preferably, the flow meter is arranged at the inlet of the water inlet pocket. Thus, the flow direction is determined upstream of the water buffer of the appliance.

In another aspect of the present disclosure a household appliance comprising the system above system is suggested. The household appliance may be a dish washer or a washing machine. The household appliance comprises the above described system and provides the control signal to an aqua stop valve of the household appliance.

In another aspect of the disclosed technology, a method for preventing backflow from a household appliance is provided. The method comprising the steps of determining a flow direction through an inlet of a household appliance, and of providing a control signal to a valve arranged upstream of the inlet of the household appliance based on the determined flow direction. Therefore, the flow of water is cut-off by the valve as soon as backward flow is detected. The method may be applied in appliances in order to fulfil regulatory requirements by providing an additional mechanism to prevent backflow into the water supply.

Preferably, the method further comprises generating a control signal based on the determined flow direction and providing the control signal to a valve arranged upstream to the inlet of the household appliance, wherein the control signal indicates to close the valve in case the determined flow direction is backwards. In accordance with the method, the valve is closed in accordance with the control signal. The method, therefore, allows to control commonly available valves in order to interrupt the flow of water between the water supply and the appliance.

In another aspect of the disclosed technology, the use of a quadrature encoder for determining a flow direction in a household appliance is suggested. The use of a quadrature encoder has the advantage that existing household appliances, for example, a dish washer or a washing machine often comprise a single channel flow meter which can be modified by adding another magnetic sensor or by replacing the single sensor with two magnetic sensors, for example, reed-sensors, hall-sensors or magneto resistive (MR) sensors, providing a two channel signal with a phase offset of 90° between the channels. Thus, the use of a quadrature encoder to determine a direction of the water flowing through a household appliance is easy and cheap to implement. The use of a quadrature encoder further allows to easily implement flow detection as only one or two additional signal are required, which can, for example, be provided to existing control circuits that can control a valve or a relay switching a valve that is already connected to the appliance.

Preferably, the quadrature encoder is used in accordance with the above described system, wherein the quadrature encoder is part of a flow meter downstream of the inlet of the household appliance and provides a two channel signal in accordance with the rotation of an impeller of the flow meter.

### Brief description of the drawings

Fig. 1 a schematic quadrature encoder
Fig. 2 signal of the two channels of a quadrature encoder
Fig. 3 signal of the two channels of a quadrature encoder
Fig. 4 a flow meter
Fig .5 a schematic diagram of a prior art system
Fig. 6 schematic diagram of the invention
Fig. 7 schematic representation of a method according to the present disclosure

### Detailed description of the drawings

The disclosed technology in general utilizes a quadrature encoder in order to detect the direction of the water flow through a flow meter. A quadrature encoder is a type of incremental encoder that converts angular or linear position information into digital signals for use in motion control systems.

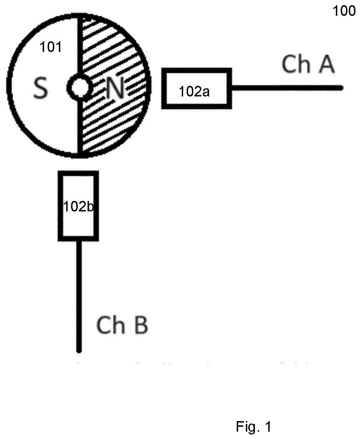

Fig. 1 shows a schematic drawing of a quadrature encoder. The encoder comprises a rotating part 1 and two sensors 2a, 2b. The rotating part 101 acts as encoder by providing an alternating signal. The encoder can be attached to a rotating part of a device. For example, a magnetic disk or a ring magnet rotates about the axis or a linear magnet rotates around the axis. In Fig. 1, the rotating magnet 101 is a two pole magnet and rotates about an axis. The rotating magnet 101 may be a ring magnet. The rotating elements may have alternating north and south poles arranged in a specific pattern. For example, half of a ring magnet may be a north pole and the other half may be a south pole, thereby providing a different orientation of the magnetic field every 180° of a rotation of the ring magnet. Two sensors 102a, 102b, in particular magnetic sensors, such as Reed Sensors or Hall-Sensors or any other magneto-resistive sensor, are arranged at an angle of preferably 90°. The angle may be any angle. The sensors provide two signals on two signal channels Ch A and Ch B. The signals are out of phase when the encoder rotates. The phase difference is caused by the different positions of the sensors. The sensors 102a, 102b may be out of phase at a predetermined angle. The signal of the sensors may be preferably 90 ° out of phase. The sensors are arranged such that the encoder or rotational element has to rotate 90° in order for the second sensor to detect or measure the same part of the encoder as the first sensor. The sensors detect changes in the magnetic field or the direction of the magnetic field and provide a corresponding output signal on the respective channel. The sensors generate a signal in accordance with the magnetic field. For example, the sensor may provide a signal that has two states. For example a high and a low state. The sensor provides a signal in accordance with one of the states in case the detected magnetic field corresponds to a north pole and provides the signal in case the detected magnetic field is a south pole. Thus, the signal indicates the direction or orientation of the magnetic field. The sensors may change the state of the sensor output signal upon a change in the direction of the orientation of the detected magnetic field. Thus, the signal may indicate a change of the direction of the magnetic field.

The phase difference of preferably 90 degrees between the two signals allows the system to determine the direction of motion. In particular, in case each sensor provides a signal for a respective sensor channel, the direction can be determined based on which one of the signals of the two sensor channels is leading. For example, the signal which changes from the low state to the high state before the other channel signal switches from low to high is leading.

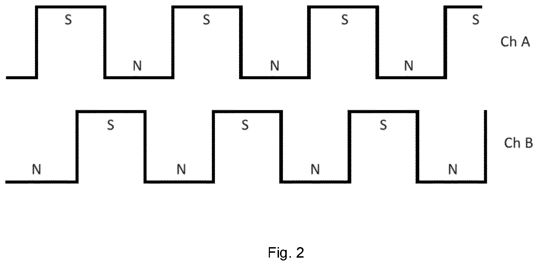

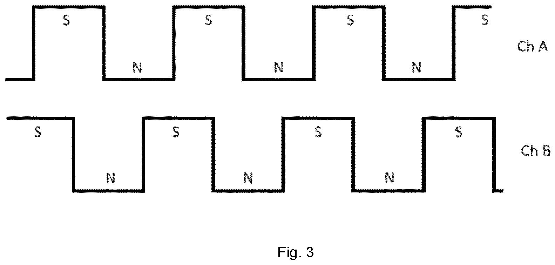

Figs. 2 and 3 shows two signals in accordance with a two pole encoder rotating in two directions, clockwise and counter-clockwise.

In Fig. 2 channel A leads channel B, the motion is in one distinct direction (e.g., clockwise).

In Fig. 3 Channel B leads Channel A, the motion is in the opposite direction (e.g., counterclockwise).

The skilled person understands that the correspondence between the direction of the rotation which signal is leading depends on the particular arrangement, in particular, on the geometric arrangement of the sensors, on the definition which channel is which, and on which magnetic orientation or which magnetic transition corresponds to the high and low part of the signal. The control electronics or circuits can be programmed in accordance with the particular arrangement in order to determine the direction of the rotation.

Thus, the quadrature encoder 100 provides two signals via two channels with respect to two sensors 102a, 102b that allow to determine the direction of the rotation of an encoder plate 101, for example a magnet that rotates about an axis, in particular a ring magnet. Quadrature encoders are known in the art. A quadrature encoder comprises circuitry that determines the direction based on the respective sensor signals received via the two channels. In the same way as an incremental encoder a quadrature encoder may still also count the number of increments in order to determine how far the rotating element has moved or how many rotations the rotating element has performed.

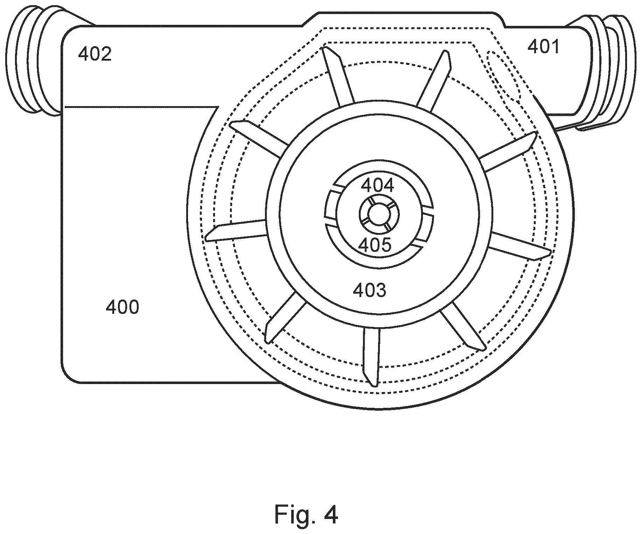

Fig. 4 shows the typical design of a flow meter 400. For example, a flow meter 400 used in a washing machine or a dishwasher that allows the control electronics to determine the amount of water flowing into the appliance. The flow meter 400 has an inlet 401 and an outlet 402. In other embodiments, the configuration of inlet 401 and outlet 402 is reversed, without affecting the ability to detect the direction of flow. The flowmeter comprises an impeller 403 that is driven by the water flowing from the inlet to the outlet, i.e. the impeller 403 is arranged so that the blades of the impeller 403 are hit be the flow of water at one side of the impeller with respect to the rotational axis 405. The impeller 403 may comprise a magnet 404, for example, a ring magnet acting as encoder disk. The flow of water causes a rotation of the impeller403 and the alternating magnetic field induces an alternating signal in a respective read out sensor (not shown), which accordingly may generate a signal each time the direction of the magnetic field changes, for example in response to a change of direction of a magnetic field caused by a ring magnet acting as encoder. In other words, the flow meter may generate a so-called tacho-signal or acts as a frequency generator. For example, a two pole magnet would cause the magnetic field detected by a sensorto change from one orientation to the other during a full revolution of the impeller 403. Thus, the sensor may provide a signal that is at one state for 180° of the revolution of the impeller and in a second state for the other 180° of the revolution of the impeller. Therefore, in case the impeller rotates at a constant velocity the sensors may produce a signal having a constant frequency corresponding to the rotational frequency with which the impeller rotates. Adding an additional set of alternating magnetic poles such that the field at the sensor alternates from north to south to north to south during a full revolution would cause the frequency of the output signal of the sensors to be double the rotational frequency of the impeller. The flow meter, therefore, counts rotations or how often one part of the encoder or the impeller 403 passes the sensor. Thus, the speed of the flow meter may be determined, but there is no information on the direction the impeller 403 turns. A reversed rotation would lead to a signal having the same frequency.

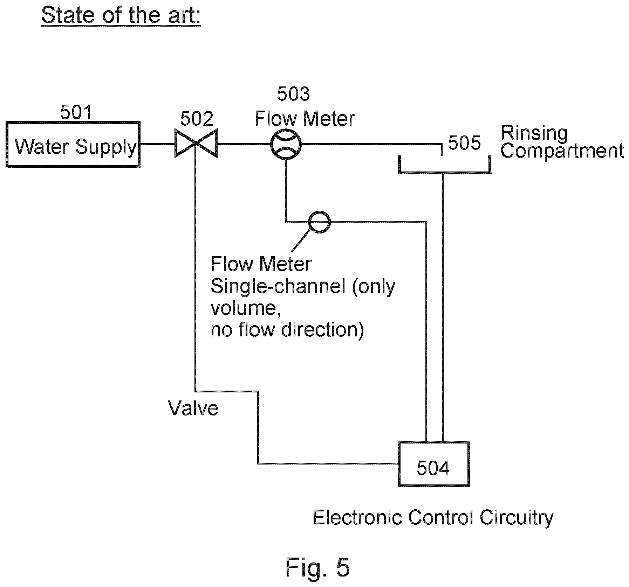

Fig. 5 shows a schematic representation of a prior art flow meter in a household appliance, for example a dishwasher or a washing machine.

The appliance is connected to the domestic water 501 supply via a valve 502, for example an aqua stop valve, which cuts-off the water supply in case of a leakage or failure. An aqua stop valve is often used in washing machines and dishwashers, and is a safety feature designed to prevent water leaks and flooding. The aqua stop system usually consists of a double-walled hose. The inner hose carries water to the appliance, while the outer hose is designed to contain any water that might leak from the inner hose. A pressure sensor or a float switch is installed at the end of the outer hose, near the connection to the appliance. This sensor detects the presence of water in the outer hose. When the sensor detects water, it triggers the aqua stop valve to close. This valve is usually located at the connection point of the hose to the water supply. Aqua stop valves may be connected to the control electronics of the appliance.

The appliance is connected to the domestic water supply 501 via a hose, the hose may be the hose of a commercially available aqua stop system as described above. An aqua stop valve 502 as described above or a water valve 502 is placed in the water flow path between the inlet of the appliance and the domestic water supply 501.

A flowmeter 503 as in general described with respect to Fig. 4 is arranged in the appliance behind or downstream of the water flow in normal operation, that is from the water supply into the appliance. The flow direction from the water supply to the appliance is the forward flow direction and the flow direction from the appliance to the water supply is a backward flow direction. The flow meter 503 measures the flow speed of the water or the amount of water that enters the appliance. For example, by generating a tacho signal in dependence on the rotational speed of an impeller of the flow meter the amount of water is determined. The flow, speed or amount of water is determined by control circuitry 504 based on the signal received from the flow meter 503. The flow meter 503 provides a single channel signal. The flow meter 503 may comprise an impeller that rotates about a rotational axis. The incoming water flow drives the impeller and therefore the flow meter allows to determine the flow, speed or amount of water. The flow meter may comprise a two pole ring magnet that rotates with the impeller.

For example, the flow meter 503 comprises sensor, for example a Reed- or Hall-sensor, that reads out the orientation of a magnetic field of a rotating magnet that rotates with the impeller driven by the incoming water flow through the flow meter 503. A magnetic sensor, for example a Reed-sensor or a Hall-sensor provides a signal that changes at least each half rotation. Thus, counting the changes in the signal allows to determine the rotational speed of the ring magnet and accordingly the rotational speed of the impeller. The outlet of the flow meter 503 may be connected to a rinsing compartment 505 of the appliance.

The appliance may comprise a water buffer, for example, an inlet water pocket. An inlet of the water buffer may be connected to the inlet of the household appliance. The water buffer may comprise the flow meter 503, wherein the inlet of the flow meter is connected to the inlet of the water buffer and the outlet of the flow meter is connected to a reservoir of the water buffer.

The electronic control circuitry 504 may control the valve 502. The electronic control circuitry may control the water flow in accordance with a predetermined program or in accordance with internal sensors of the household appliance. Upon failure detection, for example leakage, the control circuitry may close the valve. The electronic control circuitry may take into account the measured flow in order to determine the amount of water received by the appliance. The electronic control circuitry may control the appliance in dependence on the detected amount of water. The electronic control circuit may open the valve only in case the appliance needs or requests water from the water supply 501.

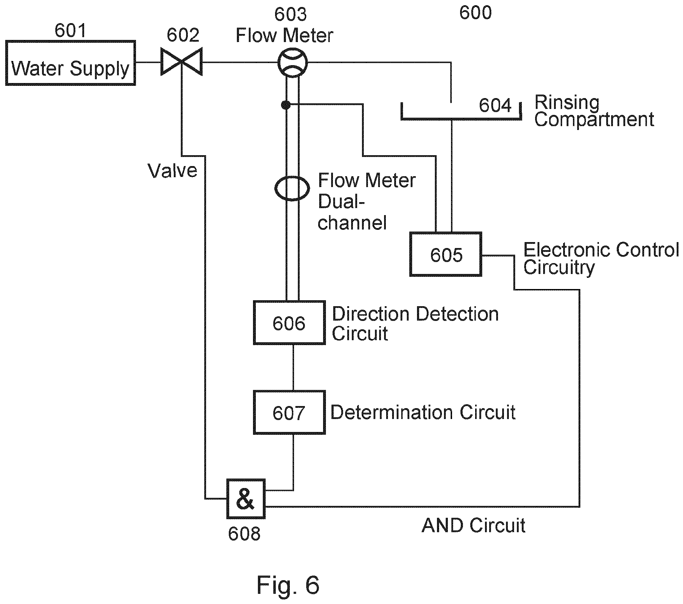

Fig. 6 is a schematic representation of the backflow prevention system according to the presently disclosed technology. The system is based on the prior art system of Fig. 5. A valve 602 is placed in the flow path of the water flowing from the domestic water supply 601 to the inlet of the appliance. A flow meter 603 according to the present disclosure is arranged downstream of the inlet of the appliance. The system comprises the flow meter. The flow meter comprises two sensors and a magnet mounted on the impeller of the flowmeter 603. The magnet is mounted in such a way that its north and its south pole are arranged adjacent to each other on a circle around the rotational axis of the impeller. The sensors are magnetic sensors. The magnetic sensors may be Reed sensors are Hall-effect sensors or any other sensors suited to measure a magnetic field or a change in magnetic field direction. The two sensors and the magnet are configured to form a quadrature encoder. Thus, the system comprises a quadrature encoder measuring the speed and the direction of the rotation of the impeller of the flow meter 603. The two sensors produce two signal provided via signal channels A and B as described above with respect to Figs. 1 to 3. The two sensors are positioned 90° apart (in quadrature) relative to the impeller movement. The disclosure is not limited to positioning the sensors at 90° apart, since any phase shift that allows to determine movement and direction suffices in the context of the present disclosure. The sensors preferably generate a signal that is 90° out of phase when the impeller is rotating. Each sensor generates for example a square wave signal based on the alternating direction of the detected magnetic field generated by the magnet moving with the rotation of the impeller. For 180° of the rotation the sensors in principle detects a north pole of the magnet and for the other 180° of rotation the sensor detects the south pole. The phase difference between the signals of the two sensors corresponds to the angle between the two sensors which is defined between two lines originating from the center of the impeller through each of the sensors.

The flow meter 603 of the present disclosure generates a two channel signal which has a phase offset in accordance with the arrangement of the sensors. In accordance with the phase offset a direction of the rotation of the flow meter and accordingly the direction of the flow of water through the flow meter can be determined. The magnetic element rotating with the flow meter 603, in particular the impeller of the flow meter 603, may define a magnetic pattern, for example the magnet may have four alternating north and south poles. In particular, the encoder disc which may be formed by the magnet or by several magnets may have any even number of alternating north and south poles.

The system 600 further comprises a direction detection circuit 606 to determine a flow direction by determining the direction in which the impeller of the flow meter rotates. The direction detection circuit 606 receives the two channel signal from the flow meter 603, in particular from the sensors of the flow meter 603, and determines which signal leads the other signal. For example, the signal of channel A leading the signal of channel B may correspond to a forward flow direction, i.e. from the inlet of the appliance through the flow meter into the appliance, for example into a rinsing compartment of the appliance. In such case, the signal of channel B leading the signal of channel A indicates that the flow direction is reversed or backwards, i.e. out of the appliance through the inlet of the appliance toward the domestic water supply. The skilled person understands that the correspondence between which channel leads and the flow direction is determined by the specific arraignment. Any combination is covered by the present disclosure. For example, channel B leading channel A may correspond to the forward direction. The correspondence between which channel leads and the flow direction is determined during set-up of the control electronics, for example during manufacturing. The correspondence may be programmed or hardwired into the circuits of the device.

The system 600 may further comprise a determination circuit 607 that determines whether the flow direction corresponds to the forward direction based on a signal received from the flow direction detection circuit 606. In other words, the determination circuit 607 compares the direction determined by the direction detection circuit 606 with a predetermined flow direction. The predetermined flow direction may by the forward flow direction. In case the signal received from the direction detection circuit 606 indicates that the flow direction is forward, the determination circuit may generate an signal indicating that the flow is normal, for example a true signal, in form of high TTL signal or analog voltage defining a high or true state. In case the direction detection circuit 606 determines that the flow direction is backward an error signal is generated by the determination unit 606. In particular, since the determination circuit 607 determines that the direction indicated by the signal received from the direction determination circuit 606 does not match the predetermined direction that corresponds to the flow direction in normal operation. For example, a false signal in form a low TTL signal or an analog voltage defining a low state may be generated by the determination circuit 607 in case the direction indicated by the signal received from the direction detection circuit 606 does not match the predetermined direction in normal operation, e.g. the forward direction. The skilled person understands that true and false states and high and low can be interchanged arbitrarily by definition, i.e. the OK state could be indicated by a low signal and the Error State could be indicated by a high signal.

The determination circuit 607 may provide a signal to the valve 602. In case the signal indicates the OK state the valve is open or opens in response to the OK signal. The valve 602 may comprise internal circuitry (or a valve driver) that - in accordance with a received control signal - opens or closes the valve. In particular the valve 602 may be switched based on logic signal, such as TTL signals, or software states like status variables using the valve driver to adapt the given logic signal to a proper valve switching signal. In some embodiments, a valve driver (not shown) is provided between AND circuit 608 and the valve. In some implementations, valve 602 is an AC valve, driven for example by 230V AC. In such implementations, the valve driver can for example by provided in the form of a TRIAC. In some implementations valve 602 is a DC valve, driven for example by a DV voltage between 12V and 320V. In such implementations, the valve driver may be provided in the form of a transistor, such as a bipolar transistor or a field-effect transistor (FET).

Preferably, the determination circuitry 607 may provide the generated signal to a logical AND circuit 608. The logical AND circuit 608 may be connected to the valve. In other words, the determination circuitry 607 may not be directly connected to the valve, but via the logical AND circuit 608.

The household appliance may further comprise electronic control circuitry 605 that controls the operation of the appliance. For example, the electronic control circuitry 605 may receive at least one signal of one channel from the flow meter 603 in order to determine the amount of water in the appliance. Thus, the electronic control circuitry 605 may only receive a tacho signal from the flow meter. However, the electronic control circuitry 605 may also receive the full two channel signal generated by the sensors of the flow meter 603. The electronic control circuitry 604 may control the operation of the appliance based at least partially on the determined amount of water flowing into the appliance. The electronic control circuitry 604 may control the operation based on measurement from sensors within the rinsing or washing compartment. In case the electronic control circuitry 605 determines that additional water is needed, the electronic control circuitry 605 may provide a true signal to logical AND 608. Accordingly, in the case the control electronics request water and the signal from the determination circuit 607 is true, i.e. the flow direction is forward, the AND generates a logic true at both inputs and provides the logic true to the valve. The valve 603 upon receiving the true signal opens and water can flow into the household appliance. Thus, only in case the flow of water is in the forward direction and the electronic control circuitry 604 requests water the valve is open. The determination circuit 607 may be configured to provide an OK signal, for example a high signal, as long as the determination circuit 607 does not determine that the flow direction indicated by the signal provided by the flow direction detection circuit 606 is indicating a backward flow direction. In other words, the output of the determination circuit 607 is true except when a flow in backward direction is indicated. Thus, the determination circuit 607 may be configured to output one state, e.g. high, of a signal and only switch the signal to the other state, e.g. low, in case the flow direction is backwards.

In case the control electronics 605 request water, the AND circuit 608 provides a true and in case the flow direction is not backward, the determination unit also provides a true signal and the AND provides a true signal to the valve. The valve may open in response to the true signal opening the valve.

For example, in case the pressure in the water supply 601 drops and the pressure drop lead to sucking the water out of the appliance, the impeller of the flow meter reverses is rotational direction. This causes the two channel signal of the flow meter to correspond to a signal indicating backward rotation. For example the sign of the phase difference between the signals on the two channels of the flow meter signal changes. The flow direction determination circuit 606 determines based on the two channel signal that the flow direction is reversed, i.e. backward, and the determination circuit 607 upon receiving a corresponding signal from the direction detection circuit 606 indicates the ERROR state by providing a false signal to the logical AND circuit 608. As one of the inputs of the logical AND 608 is low, the output is low and the signal to the valve is low. In accordance with the signal provided by the AND 608 to the valve switching from high to low the valve 602 closes. The flow meter 603 having two sensors and the two sensors generating a two channel signal that allows to determine the direction within one revolution, the valve closes before a significant amount of water behind the flow meter can flow beyond the inlet of the appliance.

Thus, the system of the flow meter 603 acting as quadrature encoder comprising two sensors proving a two channel signal based on the position of an encoder disk in form a two pole magnet and the electronic evaluation of said signal providing a corresponding control signal to the valve provides an effective measure to prevent backward flow from the appliance into the water supply. The system can be applied to known systems already having a flow meter that can only measure the speed of the impeller with one sensor by adding a second sensor.

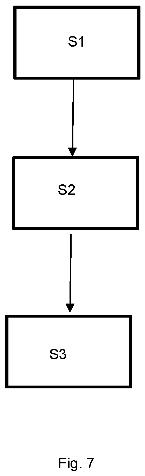

Fig. 7 is a schematic representation of a method according to the present disclosure. At step S1 the flow direction through a flow meter of a household appliance is determined. At step S2 a control signal is generated based on the determined flow direction, in particular, the determined flow direction is compared with a forward flow direction. In case the determined flow direction matches the forward flow direction, the control signal indicates that a valve between the water supply and the inlet of the appliance may be open. The control signal can be a true signal. In case the determined flow direction is backwards, the control signal indicates that the valve shall be closed, for example the control signal is a false signal or in the false state. At step S3 the valve is closed in case the determined flow direction is backward and the control signal indicates to close the valve.

A household appliance utilizing the system of Fig. 6 closes the valve up stream of the inlet of the household appliance in case flow in backward direction is detected.

Individual components or functionalities of the disclosed technology are described in the embodiment and respective examples as software or hardware solutions. However, this does not mean that a functionality described as a software solution cannot also be implemented in hardware and vice versa. Similarly, mixed solutions are also conceivable for a person skilled in the art, in which components and functionalities are simultaneously partially realized in software and hardware.

In the claims, the word "comprising" does not exclude other elements or steps, and the indefinite article "a" does not exclude a plurality.

A single unit or device may perform the functions of multiple elements recited in the claims. The fact that individual functions and elements are recited in different dependent claims does not mean that a combination of those functions and elements could not advantageously be used.

## Claims

1. System to prevent backflow from a household appliance, wherein the system comprises:
a flow meter (603) for measuring water flow, wherein the flow meter (603) comprises a quadrature encoder providing a two channel signal, and
control circuitry (606, 607) configured to:
determine a flow direction based on a first signal of the first channel and a second signal of the second channel, and
provide a control signal for a valve (602) based on the determined flow direction.

2. The system of claim 1, wherein the quadrature encoder comprises
two sensors and a magnet, and
wherein the first sensor provides a first signal provided on a first channel and the second sensor provides a second signal provided on a second channel.

3. The system of any of the preceding claims, wherein the sensors are arranged in a plane perpendicular to the rotational axis of the flow meter, and wherein the sensors are arranged on radial lines originating from the rotational axis of the flow meter and wherein the radial lines define an angle.

4. The system of claim 3, wherein the angle is between 45° and 135°, preferably 80° and 100°, more preferably wherein the angle is 90°.

5. The system of any of the preceding claims, wherein the control circuitry (607) is configured to provide a control signal that indicates the valve (602) to close in case the determined flow direction is backwards.

6. The system of any of the preceding claims, wherein the control circuitry further comprises:
a direction detection circuit (606) configured to determine a flow direction based on the two channel signal, and
a determination circuit (607) configured for comparing the determined flow direction with a preset flow direction and generating Boolean signal indicating whether the determined flow direction matches the preset flow direction,
wherein the system further comprises:
an AND gate (608), wherein the Boolean signal generated by the determination circuit (607) is provided to the AND gate, and
an electronic control circuit (605) controlling the water intake by providing a Boolean signal to initialize water flow and providing the signal to the AND gate (608), wherein the AND gate (608) is connected to an signal input of a valve (602).

7. The system of any of the preceding claims, wherein the system comprises the valve.

8. The system of claim 2, or of any of claims 3 to 7 when dependent on claim 2, wherein the flow meter comprises an impeller and the magnet rotates with the impeller, wherein the magnet is a two-pole magnet and the poles rotate on a circle around the rotational axis of the flow meter.

9. Assembly for a household appliance comprising the system of claim 1.

10. Assembly of claim 9, wherein the assembly comprises a water inlet pocket, wherein the flow meter is arranged at an inlet of the water inlet pocket.

11. House hold appliance comprising the system of claim 1, wherein the system provides the control signal to an aqua stop valve of the household appliance.

12. A method for a household appliance, the method comprising the following steps:
- determining (S1) a flow direction through an inlet of a household appliance;
- providing (S2) a control signal to a valve arranged upstream to the inlet of the household appliance based on the determined flow direction.

13. The method of claim 12 further comprising
- generating (S2) a control signal based on the determined flow direction,
- providing (S3) the control signal to a valve arranged upstream of the inlet of the household appliance, wherein the control signal indicates to close the valve in case the determined flow direction is backwards, and
- closing the valve in accordance with the control signal.

14. Use of a quadrature encoder for determining a flow direction in a household appliance.

15. Use of a quadrature encoder in accordance with claim 14, wherein the quadrature encoder is part of a flow meter downstream of an inlet of the household appliance and provides a two channel signal in accordance with a rotation of an impeller of the flow meter.
